Europäisches Patentamt
European Patent Office
Office européen des brevets

Publication number: 0 292 035 A1

# EUROPEAN PATENT APPLICATION

Application number: 88200771.9

Int. Cl.4: G01R 31/02

Date of filing: 21.04.88

Priority: 21.04.87 NL 8700941

Date of publication of application: 23.11.88 Bulletin 88/47

Designated Contracting States: BE DE FR NL

Applicant: CROON ELEKTROTECHNIEK B.V.
Schiemond 20-22
NL-3024 EE Rotterdam(NL)

Inventor: Jacobs, Aart
de Kievit 14
NL-2935 VB Ouderkerk a/d IJssel(NL)

Representative: Smulders, Theodorus A.H.J. et al
Vereenigde Octrooibureaux Nieuwe Parklaan 107
NL-2587 BP 's-Gravenhage(NL)

## A method and an apparatus for testing self-limiting electrical heating cables which are out of operation.

A method and an apparatus for testing an electrical heating cable of the self-limiting type which is out of operation. The cable comprises a pair of parallel electrical conductors. An auxiliary voltage is applied at least periodically across the two electrical conductors. The resulting current flowing through either of the two conductors is compared with the current flowing back from the other conductor. The most recent value of the currents flowing through either of the two conductors is stored. In the next test of the cable, it is established whether the instantaneous current value through the respective conductor lies beyond a given range relatively to the stored current value.

u
4
6
2
8
1
3
7
5

EP 0 292 035 A1

Xerox Copy Centre

**A method and an apparatus for testing self-limiting electrical heating cables which are out of operation.**

The present invention relates to a method of testing an electrical heating cable of the self-limiting type which is out of operation, said cable comprising a pair of parallel electrical conductors.

For heating e.g. pipelines and pipeline fittings, in e.g. the processing industry, in refineries, on drilling platforms and also long-distance pipelines for the transport of various liquids, electrical heating cables are used on a large scale. These cables are installed along the lines and fittings to be heated and can serve for keeping the liquids transported through the lines at a temperature optimal for such liquids, but also for protecting the liquids and lines only against freezing phenomena.

There are two types of electrical heating cables, the non-self-limiting type and the self-limiting type. The first type essentially consists of a resistance wire surrounded by an insulating sheath, with the ohmic resistance of the total cable and the voltage applied across it determining the quantity of heat generated. With a given length of a given type of cable and a fixed applied voltage, this quantity of generated heat is essentially constant.

The self-limiting type of heating cable includes two parallel electrical conductors having low ohmic resistance, between which conductors a potential differential can be applied. The two conductors are encapsulated in the material of a synthetic plastics tape along the two longitudinal sides thereof. This plastics tape consists of a mixture of a polymer and of conductive carbon and has the property that the ohmic resistance thereof has a positive temperature coefficient. Consequent ly, at low temperatures a relatively large current flows from one conductor through the plastics tape to the other conductor, thereby generating a relatively large quantity of heat, while at higher temperatures of the cable, substantially less current flows through the plastics material, so that the quantity of heat generated is hence also less. This means that such a self-limiting cable is highly suitable for maintaining a line at a fixed temperature at a relatively low energy consumption, while, moreover, the risk of overheating of the cable is non-existent. Self-limiting heating cables of this type are marketed e.g. under the trade name Chemelex Autotrace by the Raychem Corporation. Another type of self-limiting heating cable is known from US patent 4,072,848. This cable consists of two parallel conductors between which uniformly interspaced temperature-sensitive variable resistance elements are electrically connected in parallel. These elements, similarly to the electrically conductive synthetic plastics material, provide for the possibility of heating the cable, and limit the current, due to their temperature-sensitivity, when the desired cable temperature is reached.

In many cases a heating cable need not be operative continuously. With pipelines in the outside air for instance, the heating cable need only be energized when the ambient temperature becomes too low, so e.g. only during the winter months. During periods when the cable is inoperative and hence receives no voltage, the cable may yet be damaged e.g. from operations on or around the pipelines and by other external influences. When, after such damage, the cable is connected to a voltage source at a certain time, because the pipeline has to be heated due to e.g. the decreasing outside temperature, it will be found that the cable does not function, so that the fluids in the pipeline can solidify, which is naturally highly undesirable and may result in a prolonged shut-down in e.g. a refinery or on a drilling platform.

Heating cables of the non-self-limiting type can be inspected periodically by means of a simple measurement of the ohmic resistance of the cable, which is known as a matter of fact. Too high or too low a resistance indicates damage. In cables of the self-limiting type, a measurement of the ohmic resistance, however, gives no indication, because this resistance varies very strongly with the temperature. On the other hand, the cable of the self-limiting type is used on a large scale, in connection with the advantages going therewith. For testing an inoperative heating cable of the self-limiting type, however, there exists no sufficiently reliable method so far.

To eliminate this problem, in installations where the heating of the pipelines is critical and where cables of the self-limiting type are installed, preferably the heating cables are kept continuously connected to the working voltage, in spite of the concomitant loss of energy.

There is accordingly a need for a method of testing heating cables of the self-limiting type which are out of operation, so that when really necessary the cable can emit the desired quantity of heat, which method preferably causes little loss of energy.

It is an object of the present invention to provide such a testing method and to that end provides for a method which comprises applying an auxiliary voltage applied across the two electrical conductors at least periodically, and comparing the resulting current flowing in either of the two conductors with the current flowing back from the other conductor, storing the most recent value of the current flowing through either of the two conductors and determining in the next measurement of the same cable whether the instantaneous current value through the respective conductor lies outside a given range relatively to the stored current value.

The method of the present invention in the first place makes it possible to test in a reliable manner and at a relatively low auxiliary voltage, e.g. 10 VDC. whether a short circuit has developed between either of the conductors and/or the plastics tape and earth, e.g. because the protective sheath surrounding the two conductors is damaged. Practice has shown that about 90% of the defects in self-limiting heating cables consist in a short circuit between the cable and earth.

In the second place, the present invention provides for a second measurement by means of which three other types of fault can be detected, i.e. a short circuit between the two conductors, an interruption in the path to either of the two conductors or an unduly large change in resistance in the cable over a certain period of time due e.g. to a cut-off of a part of the cable. In this manner, the rest of the possible causes of fault can be detected, too.

When the current measured deviates by more than a predetermined percentage from the current that flowed in the preceding measurement, this means that any of the three faults mentioned has occurred. If desired, it can also be deduced from the measured current value which of the three faults has occurred. When the current measured is much too high, there is probably a short circuit between the two conductors, and when the current is much too low an interruption in the current supply to or from the conductor(s), while in the case of intermediate current values, which, however, deviate by more than the predetermined percentage from the current value in the preceding measurement, there is probably a total interruption in the cable, so that the resistance of the cable has changed at a bound. As the instantaneous current value is always compared with the current value during the preceding measurement, it is taken into account that the current may vary in time due to resistance variations in the cable. However, it is also known that this resistance variation per period of time can only be a certain percentage, so that it can be calculated how much the current can fluctuate maximally per period of time due to normal temperature variations.

The invention also provides apparatus for testing an electrical heating cable of the self-limiting type which is out of operation, said cable comprising a pair of parallel electrical conductors, said apparatus comprising, according to the invention, an auxiliary voltage source at least periodically connected to both conductors, means for measuring the current flowing in either of the conductors, means for measuring the current flowing back from the other conductor, means for comparing these two currents, means for storing the value of the current flowing through either of the two conductors and means for comparing in the next measurement the instantaneous current value in that conductor with the stored current value.

It is observed that a device for comparing the current flowing in a first conductor with the current flowing back from the second conductor is described per se in DE-Al-2639168, which publication describes a so-called differential current meter, also called earth leakage switch. Such a device, however, is known to be used as a protection against earth fault in electrical installations in houses and the like and not as supervisory circuitry for heating cables by means of a relatively low auxiliary voltage.

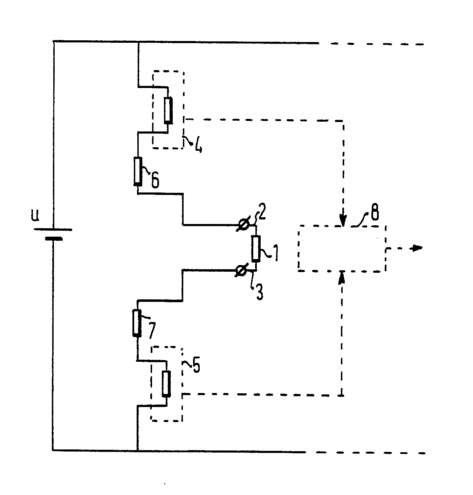

One embodiment of the present invention will now be described, by way of example, with reference to the accompanying drawing.

The figure shows a heating cable to be tested, which is of the self-limiting type, and is shown diagrammatically by a resistor 1. The cable consists of two parallel conductors 2 and 3, embedded in a synthetic plastics material having a positive temperature coefficient, so that the cable, as viewed on one end, actually behaves as a resistor. In the testing mode, cable 2 is connected through a test circuit 4 to the positive terminal of an auxiliary voltage source U and cable 3 through a test circuit 5 to the negative terminal of said auxiliary voltage source. The voltage U may be e.g. 10 VDC, so that in the testing mode a very low current of e.g. maximally 20 milliamperes flows through the cable. The power dissipated in the cable in the testing mode, consequently, is negligible relatively to the power dissipated in a cable which is actually used, which power may be 10-100 Watt/meter. With a view to restricting the current in the test circuit in the event of a fault between conductors 2 and 3, there are provided two limiter-resistors 6,7 between the first test circuit and conductor 2 and the second test circuit and conductor 3, respectively. The test circuits 4,5 serve for measuring the current flowing to conductor 2 and from conductor 3. Preferably, the test circuits are designed as analog-to-digital converters, which convert the current value measured into a digital value. These digital values are supplied to a freely programmable control device diagrammatically shown at numeral 8, which is provided in known per se manner with means for comparing the currents measured by test circuit 4 and 5 and for transmitting an alarm signal if the differential between these two currents is too large, which means that a part of the current is dissipated to earth due to an earth fault from conductor 2 or conductor 3.

The freely programmable control device is also provided with a memory circuit for storing the test value of circuit 4 or of circuit 5 and in the next measurement, for comparing the current value metered by the respective circuit with the stored current value. If the differential between these two current values is too large, this means that there is either a fault between the two conductors, in which case the current value increases excessively and is limited by the resistors 6,7, or an interruption in the connection to either of conductors 2 or 3, in which case a very low current will flow, or a shortening of cable 1, in which case the current will exhibit a proportionally larger variation relatively to the stored current value than could be expected on account of the possible resistance variation of the cable between the two measurements.

Naturally, it is possible for the four different types of faults to be detectable by means of a single alarm signal, but it will be clear to those skilled in the art that it is also possible to have a separate alarm signal generated for each of the four faults, so that it may be immediately known which type of fault has occurred. It will also be clear that it is possible to have a large number of cables periodically served from a single auxiliary voltage source, with each cable included in a test circuit of the type shown in the figure. Finally, it is pointed out that for measuring the current to conductor 2 and the current from conductor 3, for comparing these two currents and for storing either of the two current values, conventional analog techniques well known to those skilled in the art may be used. Moreover, it is possible for the cable to be tested continuously rather than periodically by continuously measuring the current through the conductors. In most cases, however, a periodical test offers a sufficiently reliable indication of the condition of the cable.

## Claims

1. A method of testing an electrical heating cable of the self-limiting type which is out of operation, said cable comprising a pair of parallel electrical conductors, characterized by at least periodically applying an auxiliary voltage across the two electrical conductors, comparing the resulting current flowing through either of the two conductors with the current flowing back from the other conductor, storing the most recent value of the currents flowing through either of the two conductors and determining in the next of the cable whether the instantaneous current value through the respective conductor lies beyond a given range relatively to the stored current value.

2. A method as claimed in claim 1, characterized in that an alarm signal is produced when it is detected during a measurement that the difference between the two currents flowing through the conductors exceeds a given threshold value or that the instantaneous current value through a conductor lies beyond a given range relatively to the value of the current through that conductor during the preceding measurement.

3. An apparatus for testing an electrical heating cable of the self-limiting type which is out of operation, said cable comprising a pair of parallel electrical conductors, characterized by said apparatus comprising an auxiliary voltage source connected at least periodically across the two conductors, means for measuring the resulting current flowing through either of the two conductors, means for measuring the current flowing back from the other conductor, means for comparing these two currents, means for storing the value of the current flowing through either of the two conductors and means for comparing during the next measurement the instantaneous current value in that conductor with the stored current value.

u
4
6
2
8
1
3
7
5

European Patent Office

# EUROPEAN SEARCH REPORT

Application Number

EP 88 20 0771

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-4 072 848 (THERMON)<br>* Abstract * | 1,3 | G 01 R 31/02 |
| Y | DE-A-2 639 168 (SIEMENS)<br>* Page 2, lines 9,10,23,24; page 3, lines 5-11; page 4 * | 1,3 | |
| A | DE-A-2 509 661 (HARMS) | | |
| A | DE-A-1 918 419 (STOTZ) | | |
| A | EP-A-0 020 047 (GENERAL ELECTRIC) | | |
| | | | TECHNICAL FIELDS SEARCHED (Int. Cl.4) |
| | | | G 01 R |

The present search report has been drawn up for all claims

| Place of search | Date of completion of the search | Examiner |
|---|---|---|
| THE HAGUE | 11-08-1988 | HOORNAERT W. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)